(19) Europäisches Patentamt / European Patent Office / Office européen des brevets

(11) **EP 2 402 287 B1**

(12) **EUROPEAN PATENT SPECIFICATION**

(45) Date of publication and mention
of the grant of the patent:
**17.10.2018  Bulletin 2018/42**

(21) Application number: **10746200.4**

(22) Date of filing: **23.02.2010**

(51) Int Cl.:
*C01B 33/035* *(2006.01)*          *B01J 4/00* *(2006.01)*
*C23C 16/455* *(2006.01)*

(86) International application number:
**PCT/JP2010/052760**

(87) International publication number:
**WO 2010/098319 (02.09.2010 Gazette 2010/35)**

(54) **POLYCRYSTALLINE SILICON ROD AND DEVICE FOR PRODUCING SAME**

STAB AUS POLYKRISTALLINEM SILIZIUM UND VORRICHTUNG ZU SEINER HERSTELLUNG

TIGE EN SILICIUM POLYCRISTALLIN ET SON DISPOSITIF DE PRODUCTION

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority:  **27.02.2009   JP 2009046498**

(43) Date of publication of application:
**04.01.2012   Bulletin 2012/01**

(73) Proprietor: **Tokuyama Corporation
Shunan-shi, Yamaguchi 745-8648 (JP)**

(72) Inventors:
• **ODA, Hiroyuki
Shunan-shi
Yamaguchi 745-8648 (JP)**
• **KOYANAGI, Shinichirou
Shunan-shi
Yamaguchi 745-8648 (JP)**

(74) Representative: **J A Kemp
14 South Square
Gray's Inn
London WC1R 5JJ (GB)**

(56) References cited:
**DE-A1- 2 321 186      JP-A- 2 006 317
JP-A- 50 015 478      JP-A- 50 018 503
JP-A- 59 115 739      US-A- 4 147 814
US-A- 5 888 293**

**Description**

Technical Field:

This invention relates to a polycrystalline silicon rod obtained by depositing polycrystalline silicon, by the chemical vapor-phase deposition method, on a silicon core member arranged in a reaction vessel in an erected manner. More specifically, the invention relates to a polycrystalline silicon rod used for the recharging in the floating zone method (FZ method) or the Czochralski method (CZ method).

Background Art:

A variety of processes have heretofore been known for producing silicon that is used as a starting material of semiconductors or wafers for solar power generation, and some of them have already been put into practice on industrial scales. For instance, one of them is a process called Siemens process in which silicon core members are provided in a reaction chamber in a bell jar, are heated by flowing an electric current thereto to a temperature at which silicon deposits and in this state, a gas of a silane compound such as trichlorosilane ($SiHCl_3$) or monosilane ($SiH_4$) is fed into the reaction chamber so that silicon deposits on the silicon core members by the chemical vapor-phase deposition method. This process has a feature in that polycrystalline silicon of a high purity is obtained in the form of rods, and has been put into practice as the most general process (see patent documents 1, 2).

Prior Art Documents:

Patent Documents:

Patent document 1: JP-A-2004-149324
Patent document 2: JP-A-2005-112662

Outline of the Invention:

Problems that the Invention is to Solve:

The silicon core members have a π(pie)-shape, each of which comprising a pair of core wires held by the electrodes and erecting on the electrodes, and a bridging wire connecting the upper ends of the core wires together. The polycrystalline silicon rods deposited on the surfaces of the silicon core members have their corners gradually rounded as the silicon deposits and grows on the surfaces of the silicon core members and are, therefore, obtained in an inverse U-shape as a whole. The polycrystalline silicon rods of such a shape are taken out, usually, with some of their portions being cut off. Besides, the straight body portions deposited and grown on the core wires erected on the electrodes are cut away from the bridge portion connected to the upper ends thereof, and are used as a starting material of single crystal silicon. Further, the shape of the polycrystalline silicon that is used differs depending upon the method of single crystallization. For example, the Czochralski method (CZ method) uses the polycrystalline silicon of the shape of a mass while the floating zone method (FZ method) uses it in the form of a rod. Moreover, the CZ method often conducts the recharging in which the polycrystalline silicon rods are directly melted in the silicon melt that is obtained by heating and melting the mass of polycrystalline silicon. The polycrystalline silicon rod used for the above object is, therefore, called polycrystalline silicon for recharging.
To use the polycrystalline silicon rods in the form of rods as in the above FZ method or the CZ method, it becomes necessary to transfer the silicon rods. However, the polycrystalline silicon rods obtained by the Siemens method, usually, have a large diameter with their straight body portions being nearly of a uniform cylindrical shape to maintain productivity of silicon. Namely, the polycrystalline silicon rods cannot be easily transferred in their own shape. As means for transferring the silicon rods, therefore, it has been attempted to form a small slit along the whole circumferences of the silicon rods by using an outer circumference cutter made of diamond, wind a wire or the like round the slit to hold the silicon rods, and lift up the silicon rods to transfer them.
To form the slit along the whole circumferences of the silicon rods, however, a special device is necessary for cutting the surfaces of the rods while rotating the rods thus accompanied by a problem of complex transfer operation.
It is, therefore, an object of the present invention to provide a polycrystalline silicon rod used for the recharging in the FZ method or the CZ method, the straight body portions of the obtained polycrystalline silicon rod assuming an easily transferable shape and excelling in transferability without the need of machining for transfer, as well as an apparatus for producing the same.

Means for Solving the Problems:

To solve the above problems, the present inventors have conducted a keen study and have discovered the fact that a diameter profile can be formed in the straight body portions of the silicon rod in the lengthwise direction thereof, i.e., a minimum diameter portion and a maximum diameter portion can be formed in the straight body portions in producing the polycrystalline silicon rod by the Siemens method.

It was, further, discovered that by utilizing the diameter profile formed in the straight body portions, the polycrystalline silicon rods of such a shape can be transferred by using a crane or the like by being simply hooked by a lifting hook without conducting any special machining for shaping, and the present invention was thus completed.

That is, according to the present invention, there is provided a polycrystalline silicon rod obtained by depositing and growing silicon, by the chemical vapor-phase deposition method, on a silicon core member which includes a pair of silicon core wires erected on electrodes and a bridging wire connecting upper ends of the silicon core wires, the polycrystalline silicon rod having straight body portions deposited and grown on the core wires and a bridging portion deposited on the bridging wire;

wherein the straight body portions of the silicon rod have a diameter profile in a lengthwise direction thereof, and a minimum diameter in the straight body portions is adjusted to be 60 to 95% of a maximum diameter thereof a recessed portion is formed in a portion of the straight body portions close to the electrodes, and the deepest portion in the recessed portion is a portion having the minimum diameter; and a ratio L/H of the position L of the recessed portion from the lower end of the straight body portion to the height H of the straight body portion, is 0.05 to 0.1.

In the present invention, the straight body portions of the silicon rod do not necessarily assume a perfectly circular shape in plane cross section but often assume an oval shape or a shape close thereto. Therefore, if a maximum diameter in the plane cross section is denoted by A and a minimum diameter by B, then the diameter of the straight body portions of the silicon rod stands for a value calculated according to the following formula,

$$\texttt{Diameter of the straight body portions} = ((A^2 + B^2)/2)^{1/2}.$$

There is disclosed a polycrystalline silicon rod obtained by depositing and growing silicon, by the chemical vapor-phase deposition method, on a silicon core member which includes a pair of silicon core wires erected on the electrodes and a bridging wire connecting upper ends of said silicon core wires, said polycrystalline silicon rod having straight body portions deposited and grown on said core wires and a bridging portion deposited on said bridging wire, wherein: the straight body portions of said silicon rod have a diameter profile in lengthwise direction thereof, and a minimum diameter in said straight body portions is adjusted to be 60 to 95% of a maximum diameter thereof; and the diameter of said straight body portion is gradually increasing from an upper side toward a lower side.

According to the present invention, further, there is provided an apparatus for producing a polycrystalline silicon rod, including a bottom plate holding a pair of electrodes; a π-shaped silicon core member which comprises a pair of silicon core wires and a bridging wire connecting the upper ends of the silicon core wires, lower ends of the silicon core wires being held and erected on the pair of electrodes; and a bell jar covering the bottom plate so as to contain the silicon core member therein; wherein a gas feed pipe and a gas discharge pipe extends, through the bottom plate, into a reaction chamber formed by the bell jar and the bottom plate, characterized in that; wherein a gas ejection nozzle is provided at an end portion of the gas feed pipe, and side ejection ports are formed in the gas ejection nozzle so as to eject gas in a transverse direction in parallel with an upper surface of the bottom plate, the height of the side ejection ports is higher than the height of upper ends of the electrodes and constructed and arranged such that blow of the reaction gas fed from the gas feed pipe locally cools the polycrystalline silicon rod to lower the rate of silicon deposition at portions to where the reaction gas is blown.

In the above production apparatus, it is desired that (4) an upper ejection port is formed together with the side ejection ports in the gas ejection nozzle so as to eject the gas in the upper direction perpendicular to the upper surface of the bottom plate.

Effects of the Invention:

The polycrystalline silicon rod obtained according to the present invention has an inverse U-shape like those produced by the known processes and has a distinguished feature in that its straight body portions have a diameter profile in the lengthwise direction thereof or, in other words, have a minimum

diameter portion and a maximum diameter portion. That is, if the straight body portions are cut apart from the bridge portion continuous thereto, then by utilizing the diameter profile, the polycrystalline silicon rod of the invention can be hanged down by using a lifting hook without the need of conducting any special machining for shaping, and can be transferred by using a crane or the like so as to be used for the recharging in the FZ method or the CZ method.

As described above, the polycrystalline silicon rod of the present invention has very excellent transportability in its straight body portions.

Further, the silicon rods of the above shape can be easily produced by using a production apparatus having specifically a structure in which the reaction gas is ejected in the transverse directions from the gas feed pipe that is extending into the reaction chamber in the bell jar. Namely, in the production apparatus of the above structure, the temperature becomes low at portions of the straight body portions of the silicon rod to where the reaction gas is blown. As a result, the deposition and growth of silicon are delayed at the portions to where the reaction gas is blown, and a recessed portion (the deepest portion becomes the minimum diameter portion) is formed in the above portions.

Brief Description of the Drawings:

[Fig. 1] is a view showing a preferred shape of the straight body portion of a polycrystalline silicon rod of the invention.
[Fig. 2] is a view showing another shape of the straight body portion of the polycrystalline silicon rod of the invention.
[Fig. 3] is a schematic view showing the state of transferring the straight body portion of the polycrystalline silicon rod of Fig. 1.
[Fig. 4] is a schematic view showing the state of transferring the straight body portion of the polycrystalline silicon rod of Fig. 2.
[Fig. 5] is a view showing, on an enlarged scale, a major portion of the silicon rod of Fig. 1.
[Fig. 6] is a side sectional view schematically illustrating the structure of a silicon production apparatus used for the production of polycrystalline silicon rods.
[Fig. 7] is a schematic bird' s eye view of when the bottom plate in the reaction chamber A of the silicon production apparatus of Fig. 6 used for the production of polycrystalline silicon rods is viewed from the upper side.
[Fig. 8] is a view showing, on an enlarged scale, an end portion of a gas feed pipe preferably used for the production of polycrystalline silicon rods of, specifically, the shape of Fig. 1 in the production apparatus of Figs. 6 and 7.

Mode for Carrying Out the Invention:

Immediately after the production, the polycrystalline silicon rod of the invention has an inverse U-shape with two straight body portions. The upper ends of the straight body portions are connected to each other via a bridge portion, and the lower ends thereof are connected to the electrodes arranged in the production apparatus that will be described later. This structure is the same as that of the conventional polycrystalline silicon rods. As described above, however, the present invention has a novel feature in regard to that a diameter profile is formed in the straight body portions.

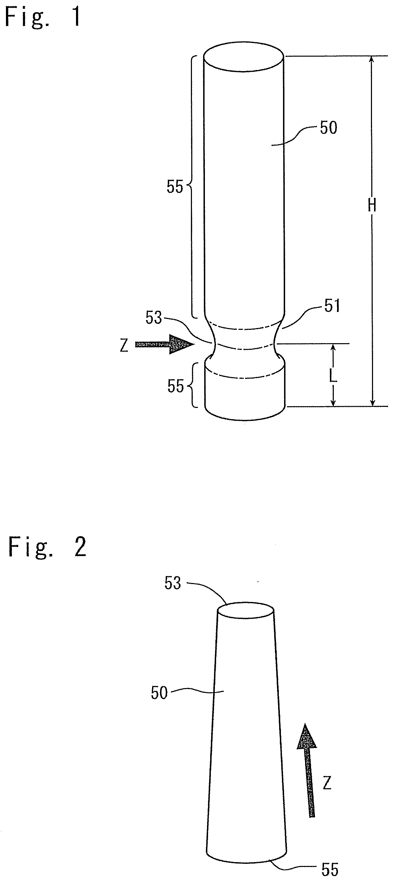

Referring to Figs. 1 and 2 showing the shapes of the straight body portions of the above forms, the straight body portions of the polycrystalline silicon rods generally designated at 50 are shown in a state where the bridge portion continuous to the upper end thereof and the electrode portion joined to the lower end thereof have been cut off.

That is, in the present invention, a diameter profile is formed in the straight body portion 50 and, therefore, a minimum diameter portion and a maximum diameter portion are formed accompanying the diameter profile.

In Fig. 1, for example, a recessed portion 51 is formed near the lower end portion of the straight body portion 50, and a minimum diameter portion 53 is present in the recessed portion 51. In this embodiment, the straight body portion 50 has a substantially cylindrical shape with the exception of the formation of the recessed portion 51. Therefore, maximum diameter portions 55 correspond to the regions excluding the recessed portion 51.

Referring to Fig. 2, further, the outer surface of the straight body portion 50 is tapered. In Fig. 2, the upper end portion is the minimum diameter portion 53 and the lower end portion is the maximum diameter portion 55, the diameter gradually increasing from the upper end toward the lower end.

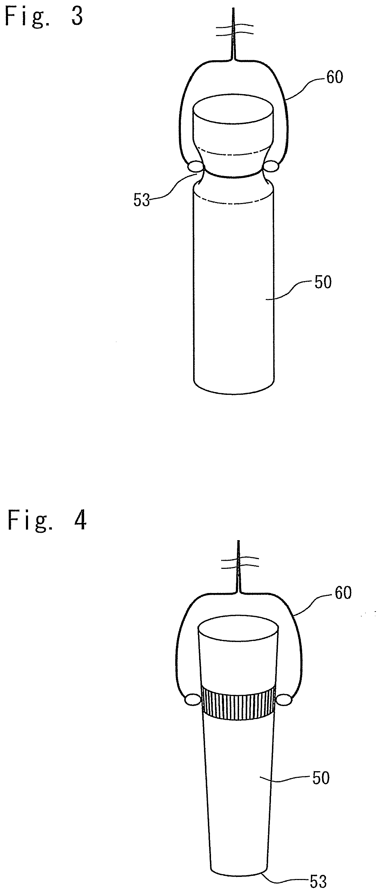

That is, by utilizing the diameter profile, the straight body portion 50 that has been cut as described above can be transferred being hooked by using a lifting hook 60 of a crane as shown in Figs. 3 and 4. For example, the straight body portion 50 having the diameter profile as shown in Fig. 1 can be held in a state of upside down, and can be transferred with the recessed portion 51 having the minimum diameter portion 53 being hooked by the lifting hook 60.

There is no particular limitation on the position L of the recessed portion 51 from the lower end portion of the straight body portion 50 in the shape of Fig. 1 above provided it can be hooked by the lifting hook 60 and transferred. From the standpoint of stability at the time of transfer by being hooked by the lifting hook 60, however, it is desired that a ratio (L/H) thereof to the height H of the straight body portion 50 is in a range of 0.05 to 0.1.

Further, the straight body portion 50 having a diameter profile as shown in Fig. 2 can be transferred without any inconvenience if it is held upside down and is lifted up by using the lifting hook 60 since the upper side thereof is the maximum diameter portion 55 and the upper portion of the straight body portion 50 can be firmly held by using the lifting hook 60.

There is no particular limitation on the lifting hook used for transferring the polycrystalline silicon rods of the present invention, and there can be used a known lifting hook that has been used for transferring the polycrystalline silicon rods. As the lifting hook, there can be concretely exemplified those lifting hooks having, as shown in Figs. 3 and 4, a holding portion such as wire or belt for holding the polycrystalline silicon rod and a connection portion for connecting the holding portions to a wire or the like for transfer. As shown in Figs. 3 and 4, the lifting hook can transfer the polycrystalline silicon rod in a hanging manner with its holding portion such as wire or belt wound on the silicon rod and the connection portion being connected to the wire or the like for hanging and transfer.

In the present invention, there is no particular limitation on the form of diameter profile of the straight body portion 50 described above. For example, the position of the minimum diameter portion 53 is not limited to the positions shown in Figs. 1 and 2. As other examples that are not shown, there can be mentioned, for example, a shape forming a tapered surface on a region from one end of the straight body portion up to a given position of the straight body portion. In the case of such a shape, if the region forming the tapered surface is present being deviated toward one region relative to the center of gravity of the polycrystalline silicon rod, then the stability of the polycrystalline silicon rod decreases when it is transferred by being hooked by the lifting hook. It is, therefore, desired that the minimum diameter portion and the maximum diameter portion forming the tapered surface are present holding the center of gravity of the polycrystalline silicon rod therebetween.

Contrary to the above, further, the shape of Fig. 2 may be such that the minimum diameter portion of the straight body portion is located near the electrode at the lower end thereof, the diameter gradually increases from the minimum diameter portion toward the upper side, and a portion located near the upper portion that bends into the U-shape is the maximum diameter portion. Usually, the polycrystalline silicon rod obtained by the Siemens method contains carbon or the like which is the material of the electrode in relatively large amounts in a portion thereof near the electrode. When the polycrystalline silicon rod is to be used for the recharging in the FZ method or the CZ method, therefore, the portion near the electrode must be cut off to some extent so as to use those portions having a less carbon content. However, the polycrystalline silicon rod of the shape shown in Fig. 2 has the maximum diameter portion of the straight body portion near the electrode and can, therefore, be used for the recharging in the FZ method or the CZ method without the need of unnecessarily cutting off the silicon rod offering advantage in that the obtained polycrystalline silicon rod can be efficiently used as compared to the polycrystalline silicon rods of the shapes in which the minimum diameter portions of the straight body portions are located near the electrode at the lower ends thereof.

Among the shapes of the polycrystalline silicon rods of the present invention described above, the shapes of Figs. 1 and 2 are preferred from the standpoint of easy hooking by using the lifting hook and a high stability of the polycrystalline silicon rod of when it is transferred by using the lifting hook. The most desired is the silicon rod of the shape shown in Fig. 1.

In the present invention, further, the diameter of the minimum diameter portion 53 should be in a range of 60 to 95% of the maximum diameter. That is, if the minimum diameter is larger than the above range, the difference between the minimum diameter and the maximum diameter becomes so small that the polycrystalline silicon rod cannot be easily hooked by the lifting hook 60 and the transferability decreases. If the minimum diameter is smaller than the above range, on the other hand, there is no change in the transferability of the polycrystalline silicon rod of Fig. 1 but the strength of the polycrystalline silicon rod decreases, and the polycrystalline silicon rod tends to be easily collapsed while the rod is being produced.

With the polycrystalline silicon rod of the shape of Fig. 2, further, the larger the inclination of the tapered surface, i.e., the smaller the minimum diameter, the more excellent the stability of when the silicon rod is hooked by the lifting hook 60, i.e., the more excellent the transferability. However, if the minimum diameter is too small, the amount of silicon per a rod greatly decreases as compared to the polycrystalline silicon rod of a cylindrical shape, and the polycrystalline silicon rod becomes less efficient when used for the recharging in the FZ method or the CZ method and is not desirable. It is desired that the diameter of the minimum diameter portion 53 of the silicon rod of the shape shown in Fig. 2 is in a range of 70 to 95% and, particularly, 80 to 90% of the maximum diameter from the standpoint of efficiently obtaining the polycrystalline silicon rod having excellent transferability.

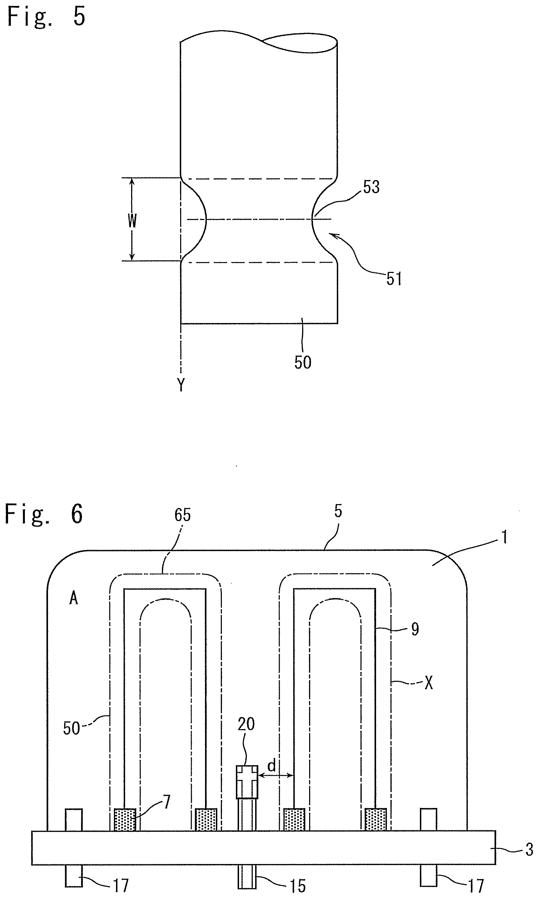

Further, referring to Fig. 5 which shows, on an enlarged scale, a major portion of the silicon rod of Fig. 1 which is an optimum shape of the present invention, it is desired that the recessed portion 51 has a width W which is, usually, in a range of 400 to 100 mm and, particularly, 200 to 100 mm. If the width W is too small or is too large, the silicon rod cannot be easily hooked by the lifting hook 60 or the lifting hook 60 may lose stability when the recessed portion 51 is hooked by the lifting hook 60.

In this embodiment, the upper and lower portions of the recessed portion 51 are substantially of a cylindrical shape. The silicon rod, however, is obtained by a chemical reaction but not by a mechanical method. Therefore, the diameters thereof tend to fluctuate and, particularly, tend to greatly fluctuate toward the upper portion and the lower end portion of the silicon rod. Therefore, the width W of the recessed portion 51 can be accurately calculated desirably by, for example, drawing a sheathing line (tangential line) Y along the outer circumferential surface of the rod and calculating the width W of the recessed portion 51 with the sheathing line Y as a reference.

<Production of silicon rods>

The polycrystalline silicon rod of the invention having the straight body portions 50 of the above-mentioned shape is produced by establishing a deposition rate profile for the diameter profile of the straight body portions 50 of the rod being produced. The method of production will now be described.

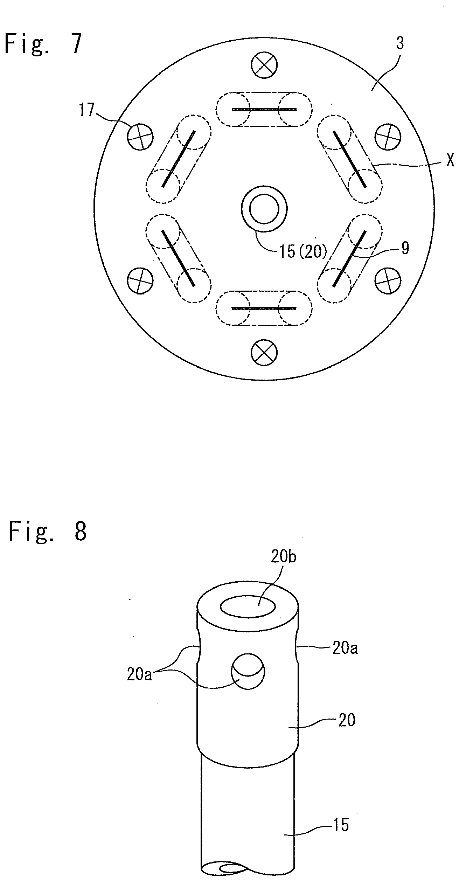

Referring to Figs. 6 and 7, the production apparatus used for the production of polycrystalline silicon rods of the invention is generally designated at 1 and is basically the same as the known one. That is, the apparatus 1 has a reaction chamber A formed by covering a bottom plate 3 with a bell jar 5. The bottom plate 3 is provided with electrodes 7 insulated from the bottom plate. On the bottom plate 3 are, further, erected silicon core members 9 (formed in a $\pi$-shape) each of which including a pair of silicon core wires rising from the electrodes 7 and connected thereto, and a bridging wire connecting the upper ends of the silicon core wires together. The silicon members 9 are heated by the flow of an electric current through the electrodes 7.

In the past, the bridging portion was made of graphite. Nowadays, however, the bridging portion is chiefly made of silicon from the standpoint of obtaining polycrystalline silicon rods of a high purity.

Referring to Fig. 7 showing six silicon core members 9, the silicon core members 9 are, usually, provided in a plural number depending upon the volume of the reaction chamber A. The silicon core members 9 are erected each being connected to the electrode 7, and are heated by flowing an electric current thereto.

It is also allowable to cover the outer surface of the bell jar 5 or the bottom plate 3 with a cooling jacket (not shown) so that the inner wall of the reaction chamber A can be easily cooled.

A gas feed pipe 15 and gas discharge pipes 17 are inserted in the thus formed reaction chamber A via the bottom plate 3. A predetermined reaction gas is fed into the reaction chamber A through the gas feed pipe 15, and unreacted gas and gases of by-produced compounds are discharged from the reaction chamber A through the gas discharge pipes 17.

By using the above silicon production apparatus 1, the polycrystalline silicon rods are produced as described below.

That is, the temperature of the silicon core members 9 is elevated to be higher than a temperature at which silicon deposits by flowing an electric current into the silicon core members 9 via the electrodes 7. When the chlorosilane gas is a trichlorosilane as will be described later, the temperature at which silicon deposits is not lower than about 900°C. In order for the silicon to be quickly deposited on the silicon core members 9, however, the electric current is, usually, flown into the silicon core members 9 so as to maintain a temperature of about 1000 to about 1100°C.

Simultaneously with the start of flowing electric current to the silicon core members 9 or at a moment when the temperature of the silicon core members 9 has reached a temperature higher than the temperature at which the silicon deposits, the chlorosilane gas and a carrier gas are fed as the reaction gas into the reaction chamber A to form silicon. As the chlorosilane gas, use is made of such a chlorosilane gas as trichlorosilane (hereinafter abbreviated as TCS) or dichlorosilane alone, or a plurality of chlorosilane gases as a mixed gas. Usually, the TCS gas is preferably used. As the carrier gas, further, use is made, in many cases, of a reducing hydrogen gas.

The silicon (Si) formed by feeding the reaction gas deposits on the silicon core members 9. By continuing the reaction, the silicon grows on the silicon core members 9 and, finally, silicon rods X comprising the polycrystalline silicon are obtained.

In a stage when the polycrystalline silicon rods X of a predetermined thickness are obtained as described above, the reaction is terminated, flow of electric current to the silicon core members 9 is interrupted, the chlorosilane gas, hydrogen gas, by-produced silicon tetrachloride and hydrogen chloride are discharged from the reaction chamber A, the interior of the reaction chamber A is purged with a safe gas, the bell jar 5 is opened, and the polycrystalline silicon rods X are taken out.

The thus formed polycrystalline silicon rods X have their corners gradually rounded as they deposit on the silicon core members 9 and, therefore, have an inverse U-shape as a whole with two straight body portions 50 which are coupled at the lower ends thereof to the electrodes 7 and are connected at the upper ends thereof to a bridging portion 65 that is coupling the two straight body portions 50 together.

In the present invention, the straight body portions 50 formed as described above have a diameter profile in the lengthwise direction thereof and have a shape shown in, for example, Fig. 1 or 2 above. To realize such a shape, a deposition rate profile corresponding to the diameter profile of the straight body portions 50 of the polycrystalline silicon rod X is established by using the reaction gas fed into the reaction chamber A from the gas feed pipe 15.

Though the mechanism of depositing silicon on the silicon core member and on the surfaces of the polycrystalline silicon rod has not been clarified yet, it is considered that the deposition varies depending upon the temperature on the surfaces of the polycrystalline silicon rod and the concentration of the reaction species formed from the chlorosilane present near the surfaces. Therefore, the rate of depositing silicon on the surfaces of the polycrystalline silicon rod can be adjusted by adjusting the feeding rate and flow rate of the chlorosilane gas fed into the reaction chamber A and the temperature of the chlorosilane gas.

<Production of the polycrystalline silicon rods having straight body portions of the shape of Fig. 1>

To form the polycrystalline silicon rod X having straight body portions of the shape shown in Fig. 1, it is desired that an ejection nozzle 20 is attached to an end as shown specifically in Fig. 8, and the directions in which the reaction gas is blown are limited by the ejection nozzle 20.

That is, the ejection nozzle 20 is provided with side ejection ports 20a for blowing the reaction gas in the transverse direction in parallel with the upper surface of the bottom plate 3, and the reaction gas is blown from the side ejection ports 20a directly onto portions where the recessed portions are to be formed in the straight body portions 50 of the polycrystalline silicon rod X (silicon core member 9 in the early stage of the reaction) . That is, since the reaction gas fed from the gas feed pipe 15 has a temperature lower than the temperature on the surfaces of the polycrystalline silicon rod X, the surfaces of the polycrystalline silicon rod X are locally cooled by the blow of the reaction gas making it possible to greatly lower the rate of silicon deposition at the portions to where the reaction gas is blown and, therefore, to quickly form the recessed portions.

As will be understood from the above description, further, the ejection nozzle 20 (particularly, side ejection ports 20a) is located at a position higher than the upper ends of the electrodes 7, as a matter of course.

It is desired that the ejection nozzle 20 is provided at its upper end surface with an upper ejection port 20b for blowing the gas upward perpendicularly to the upper surface of the bottom plate 3 in addition to the side ejection ports 20a. This nozzle 20 enables the reaction gas to be blown in the transverse direction and upward simultaneously. Namely, with the structure which blows the reaction gas in the transverse direction only, the concentration of the reaction gas decreases in the upper part of the reaction chamber A and, as a result, the upper portion of the obtained silicon rod X assumes a popcorn shape which often becomes brittle. To avoid such an inconvenience, it is desired to employ the structure which blows the reaction gas upward, too.

In the embodiment of Fig. 8, the nozzle 20 has a cylindrical shape. Not being limited thereto only, however, it is also allowable to form the nozzle 20 like, for example, a ring, and arrange the ring-like nozzle 20 so as to surround the polycrystalline silicon rod X.

There is no particular limitation on the materials of the gas feed pipe 15 and the nozzle 20 provided they do not contaminate the reaction gas that is fed; i.e., the materials may be, for example, silicon, silicon carbide, graphite or graphite of which the surfaces are coated with silicon.

Referring to Fig. 6, there is no particular limitation on the distance d between the nozzle 20 and the surfaces of the silicon core members 9 provided the reaction gas can be directly blown onto the portions where the recessed portions are to be formed in the straight body portions 50 of the polycrystalline silicon rods X, and the distance may be suitably determined by taking into consideration the size of the polycrystalline silicon rods X that are to be formed. If the distance is too small, however, the cooling effect becomes so high that the diameter of the recessed portion that is formed becomes too small. If the distance is too large, on the other hand, the cooling effect becomes low, which is not efficient. When it is attempted to form the polycrystalline silicon rod X of, for example, a maximum diameter of 120 mm having straight body portions of a height of 2 m, the distance d may be sufficient if it is suitably determined over a range of 50 to 300 mm.

There is no particular limitation on the temperature of the reaction gas blown from the gas feed pipe 15 (nozzle 20) onto the silicon core members 9 under a condition where the polycrystalline silicon rods X of the shape of Fig. 1 are to be formed, and the temperature of the reaction gas may be suitably determined by taking into consideration the size of the bell jar 5, the number of the silicon core members 9 to be installed, the size of the polycrystalline silicon rods X to be formed, and the reaction time for depositing silicon. However, the reaction gas of a too low temperature requires a device for cooling the reaction gas causing the apparatus to become complex, and is not desirable. On the other hand, the reaction gas of a too high temperature lowers the effect for cooling the portions where the recessed portions are to be formed, and is not desirable, either. When the TCS is used as the chlorosilane gas, therefore, it is desired that the temperature of the reaction gas is suitably set over a range of room temperature to 700°C.

Further, there is no particular limitation on the rate of feeding the reaction gas provided the surfaces of the polycrystalline silicon rods X can be locally cooled at portions where the recessed portions are to be formed and the rate of silicon deposition can be locally decreased. Namely, the rate of feeding the reaction gas may be suitably determined by taking into consideration the size of the bell jar 5, the number of the silicon core members 9 to be installed, the size of the polycrystalline silicon rods X to be formed, and the reaction time for depositing silicon. Generally, to maintain a predetermined rate of deposition, the flow rate of the reaction gas is, in many cases, increased accompanying the progress of the deposition reaction. For example, when the silicon of a maximum diameter of 110 to 120 mm is to be obtained and if the nozzle 20 is provided with the side ejection ports 20a of a diameter of 5 mm, the flow rate of the reaction gas blown from the side ejection ports 20a will be sufficient if it is about 10 to 30 m/s in terms of the linear velocity just before the end of the silicon deposition reaction (i.e., at the time when the polycrystalline silicon rods X have grown to a maximum diameter of 120 mm).

Upon adjusting the flow rate ratio (A/B) of the flow rate (A) of the reaction gas blown out from the side ejection ports 20a and the flow rate (B) of the reaction gas blown out from the upper ejection port 20b, further, the width W of the recessed portion 51 formed in the silicon rod X can be adjusted. That is, the larger the value of the flow rate ratio (A/B), the smaller the width W of the recessed portion 51, and the smaller the value of the flow rate ratio (A/B), the larger the width W of the recessed portion 51. Therefore, by utilizing this, i.e., by suitably varying the flow rate ratio (A/B), the width W of the recessed portion 51 can be increased or decreased.

<Production of the polycrystalline silicon rods having straight body portions of the shape of Fig. 2>

Further, to form the polycrystalline silicon rods X having straight body portions of the shape shown in Fig. 2, it is necessary to establish such a deposition rate profile that the silicon deposits at an increased rate on the lower end portion of the straight body portions 50 of the silicon rods X but the rate of deposition decreases toward the upper side. As means for establishing the above deposition rate profile, there can be exemplified means for decreasing the amount of the chlorosilane gas that is fed into the reaction chamber A.

That is, upon being fed into the reaction chamber A from the gas feed pipe 15, the reaction gas rises in the Z-direction in Fig. 2 along the surfaces of the straight body portions 50 of the polycrystalline silicon rods X due to heat convection. However, the deposition reaction is taking place on the surfaces of the polycrystalline silicon rods X consuming the chlorosilane gas in the reaction gas. Near the surfaces of the straight body portions 50 of the polycrystalline silicon rods X, therefore, the concentration of the chlorosilane gas is high at the lower end portions of the polycrystalline silicon rods X and decreases toward the upper side. By feeding the chlorosilane gas in very decreased amounts into the reaction chamber A, therefore, the chlorosilane gas becomes in short supply toward the upper side of the polycrystalline silicon rods X near the surfaces of the polycrystalline silicon rods X, the rate of deposition greatly decreases and, therefore, the above deposition rate profile can be established on the straight body portions 50 of the polycrystalline silicon rods X.

In order to form the polycrystalline silicon rods X having straight body portions of the shape shown in Fig. 2, the conditions for feeding the reaction gas into the reaction chamber A are not particularly limited if the above deposition rate profile can be established, and may be suitably determined by taking the size of the bell jar 5 and the like into consideration. From the standpoint of easily establishing the above deposition rate profile, the conditions for feeding the reaction gas are desirably such that the chlorosilane gas is fed in a decreased amount into the reaction chamber A. If the amount thereof is too small, however, an extended period of time is required for obtaining the polycrystalline silicon rods of a sufficiently large size, which cannot be said to be industrially efficient. Further, since the concentration of the reaction gas becomes very low in the upper part of the reaction chamber A, the silicon rods X assume the shape of a popcorn at the upper portions thereof as described above and become brittle. Therefore, when the TCS is used as the chloroilane gas and the silicon is deposited at 1000°C, the conditions for feeding the reaction gas into the reaction chamber A are, for example, feeding the chlorosilane gas in an amount in a range of 0.02 to 0.07 mols/cm$^{2}$· h and, particularly preferably, 0.04 to 0.06 mol/cm$^{2}$·h per the surface area of silicon.

Further, from the standpoint of increasing the rate of silicon deposition near the surfaces of the lower end portions of the straight body portions 50 of the polycrystalline silicon rods X, it is desired that the reaction gas fed into the reaction chamber A has a high temperature. However, the reaction gas of too high temperatures is not desirable causing such troubles as contamination from the pipes, decreased purity of the product and deteriorating the pipes. Therefore, when the TCS is used as the chlorosilane gas, it is desired that the temperature of the reaction gas is set in a range of room temperature to 500°C and, particularly, in a range of 200 to 350°C.

As for the shape of the gas feed port 15 for forming the polycrystalline silicon rods X having straight body portions of the shape of Fig. 2 above, there is no particular limitation if it is capable of feeding the reaction gas in the above feeding amounts into the reaction chamber A, and the gas feed port of any known shape can be used.

As another means for forming the polycrystalline silicon rods X having straight body portions of the shape shown in Fig. 2, further, there can be employed means for lowering the surface temperature at the upper portions of the polycrystalline silicon rods X by increasing the height of the ceiling of the bell jar 5 relative to the height of the straight body portions 50 of the polycrystalline silicon rods X, and decreasing the amount of infrared rays reflected by the inner wall of the bell jar 5 near the bridging portions 65 of the polycrystalline silicon rods X. When the polycrystalline silicon rods X having straight body portions of a height of, for example, 2 m are to be formed, the height of the ceiling of the bell jar 5 from the bottom plate in the above means is sufficient if it is suitably selected over a range of not smaller than 3 m.

<Treatment after the deposition reaction>

The silicon rod X having a diameter profile thus formed in the straight body portions 50 thereof is separated away from the electrodes 7 in a customary manner by cutting the vicinities of the lower end portions of the straight body portions 50, is separated away from the bridging portion 65 by cutting the upper end portions of the straight body portions 50, and is lifted up by using the lifting hooks 60 that meet the shape of the straight body portions as shown in Fig. 3 or 4.

The straight body portions cut from the polycrystalline silicon rod of the invention can be easily transferred without the need of machining for shaping, making it possible to greatly decrease the amount of work needed for the transfer.

EXAMPLES

The invention will now be more concretely described by way of Examples to which only, however, the invention is in no way limited.

<Example 1>

Polycrystalline silicon rods were produced by using the production apparatus shown in Figs. 6 and 7.

Here, the nozzle 20 having an upper ejection port and four side ejection ports was attached to an end portion of the gas feed pipe 15. The diameter of the upper ejection port (inner diameter at the end portion of the nozzle 20) was 20 mm and the diameters of the four side ejection ports were 5 mm each.

The end position of the nozzle 20 was set to a height of 400 mm from the bottom plate, and the positions of the four side ejection ports were set to a height of 300 mm each from the bottom plate 3.

Further, $\pi$-shaped silicon core members 9 made of a fine rod of a square of 8 mm and a height of 2.2 m were erected on the electrodes 7 on the bottom plate 3.

The distance d between the gas feed pipe 15 (nozzle 20) and the silicon core members 9 was set to be 200 mm.

An electric current was flown to the silicon core members 9 via the electrodes 7. At a moment when the temperature has reached 1000°C on the surfaces of the silicon core members 9, the reaction gas of TCS and hydrogen mixed in advance at a ratio of 1: 5 and heated at 25°C was fed from the gas feed pipe 15 through the nozzle 20.

Here, the amount of feeding the gas was so adjusted that the amount of the TCS gas that was fed was maintained to be $0.09 \pm 0.01$ mols/cm$^2\cdot$ h per the surface area of the silicon rod accompanying an increase in the diameter of the silicon rods deposited on the surfaces of the silicon core members 9, and the silicon deposition reaction was conducted until the straight body portions have gained a maximum diameter of 120 mm.

The reaction gas fed from the gas feed port 15 possessed a linear velocity of about 18 m/s just before the end of the reaction.

After the end of the reaction, the reaction gas was no longer fed, no electric current was supplied to the silicon core members 9, the straight body portions 50 were cut at the vicinities of the lower end portions thereof and were separated from the electrodes 7. Further, the straight body portions 50 were cut at the upper end portions thereof and were separated from the bridging portion 65, and the polycrystalline silicon rods of a length of 2 m were taken out; i.e., there were obtained the polycrystalline silicon rods having the recessed portion 51 formed near the lower ends of the straight body portions 50.

The minimum diameter portion was located 20 cm over the lower end of the polycrystalline silicon rod, and possessed a minimum diameter of 109 mm (91% of the maximum diameter). Further, the recessed portion was 150 mm wide.

The obtained polycrystalline silicon rods could be transferred without any problem being hooked at their recessed portions by using the lifting hooks.

<Examples 2 to 4>

Polycrystalline silicon rods were produced in the same manner as in Example 1 but setting the diameter of the upper ejection port of the nozzle 20 (inner diameter at the end portion of the nozzle 20) and the diameters of the four side ejection ports to be as shown in Table 1. The minimum diameters and the widths of the recessed portions were as shown in Table 1.

[Table 1]

| | | Diameters of ejection ports | | Min. diameter portion. Ratio to max. diameter (mm) of upper portion (%) | Width of recessed portion mm |
|---|---|---|---|---|---|
| | | Upper (nm) | Side (mm) | | |
| | Ex. 2 | 21 | 4 | 114mm 95% | 154 |
| | Ex. 3 | 17 | 7 | 94mm 78% | 137 |
| | Ex. 4 | 10 | 10 | 73mm 61% | 111 |

<Example 5>

Silicon rods were produced by using the production apparatus shown in Figs. 6 and 7.

Here, the inner diameter of the gas feed pipe 15 was set to be 40 mm, nozzle 20 was not provided, and the $\pi$-shaped silicon core members 9 made of a fine rod of a square of 8 mm and a height of 2.2 m were erected on the electrodes 7.

Like in Example 1, an electric current was flown into the silicon core members 9 and at a moment when the temperature reached 1000°C on the surfaces of the silicon core members 9, the reaction gas of TCS and hydrogen mixed in advance at a ratio of 1:5 and heated at 200°C was fed from the gas feed pipe 15.

The amount of feeding the reaction gas was so adjusted that the amount of the TCS gas that was fed was maintained to be $0.04 \pm 0.005$ mols/cm$^2 \cdot$ h per the surface area of the silicon rod accompanying an increase in the diameter of the silicon rod, and the silicon deposition reaction was conducted until a maximum diameter was 110 mm.

The reaction gas fed from the gas feed port 15 possessed a linear velocity of about 18 m/s just before the end of the reaction.

After the end of the reaction, the polycrystalline silicon rods of a length of 2 m were taken out in the same manner as in Example 1; i.e., there were obtained the polycrystalline silicon rods of the shape shown in Fig. 2.

The minimum diameter portion was the upper end portion of the straight body portion 50, and possessed a minimum diameter of 88 mm (80% of the maximum diameter).

The obtained silicon rods could be transferred without any problem being so hooked by using the lifting hooks that the maximum diameter portions were on the upper side.

<Example 6>

The silicon deposition reaction was conducted in the same manner as in Example 2 but so feeding the reaction gas that the amount of the TCS gas that was fed was $0.03 \pm 0.005$ mols/cm$^2 \cdot$ h per the surface area of the silicon rod.

After the end of the reaction, the polycrystalline silicon rods of a length of 2 m were taken out in the same manner as in Example 2; i.e., there were obtained the polycrystalline silicon rods of the shape shown in Fig. 2.

The minimum diameter portion was the upper end portion of the straight body portion 50, and possessed a minimum diameter of 79 mm (72% of the maximum diameter).

The obtained silicon rods could be transferred without any problem being so hooked by using the lifting hooks that the maximum diameter portions were on the upper side.

<Comparative Example 1>

The silicon deposition reaction was conducted in the same manner as in Example 2 but so feeding the reaction gas that the amount of the TCS gas that was fed was $0.09 \pm 0.005$ mols/cm$^2 \cdot$ h per the surface area of the silicon rod.

After the end of the reaction, the polycrystalline silicon rods of a length of 2 m were taken out in the same manner as in Example 2 to find that the minimum diameter was 108 mm (98% of the maximum diameter). The outer surfaces of the silicon rods had been tapered and tilted without any recessed portion.

Description of Reference Numerals:

3: bottom plate
5: bell jar
7: electrodes
9: silicon core members
15: gas feed pipe
17: gas discharge pipes
20: nozzle
20a: side ejection ports of the nozzle
20b: upper ejection port of the nozzle
50: straight body portions
51: recessed portion
53: minimum diameter portion
55: maximum diameter portion
60: lifting hook
65: bridging portion
X: silicon rods
Z: direction in which the reaction gas is blown

## Claims

1. A polycrystalline silicon rod obtained by depositing and growing silicon, by the chemical vapor-phase deposition method, on a silicon core member which includes a pair of silicon core wires erected on electrodes and a bridging wire connecting upper ends of said silicon core wires, said polycrystalline silicon rod having straight body portions (50) deposited and grown on said core wires and a bridging portion deposited on said bridging wire; wherein:

   the straight body portions (50) of said silicon rod have a diameter profile in a lengthwise direction thereof, and a minimum diameter in said straight body portions is adjusted to be 60 to 95% of a maximum diameter thereof; a recessed portion (51) is formed in a portion of the straight body portions (50) close to the electrodes, and the deepest portion in the recessed portion is a portion having the minimum diameter; and a ratio L/H of the position L of the recessed portion (51) from the lower end of the straight body portion (50) to the height H of the straight body portion (50), is 0.05 to 0.1.

2. A polycrystalline silicon rod obtained by cutting apart the straight body portions (50) and the bridging portion of the polycrystalline silicon rod of claim 1 in a manner of the polycrystalline silicon rod retaining said recessed portion (51) so as to be used for transfer.

3. An apparatus for producing the polycrystalline silicon rod (x) of claim 1, the apparatus including a bottom plate (3) holding a pair of electrodes (7) ; a π-shaped silicon core member (9) which comprises a pair of silicon core wires and a bridging wire connecting upper ends of said silicon core wires, lower ends of said silicon core wires being held and erected on said pair of electrodes (7) ; and a bell jar (5) covering the bottom plate (3) so as to contain said silicon core members (9) therein; wherein a gas feed pipe (15) and a gas discharge pipe (17) extends, through said bottom plate (3), into a reaction chamber (A) formed by said bell jar (5) and said bottom plate (3), **characterized in that**:
   a gas ejection nozzle (20) is provided at an end portion of said gas feed pipe (15), and side ejection ports (20a) are formed in said gas ejection nozzle (20) so as to eject gas in a transverse direction in parallel with an upper surface of said bottom plate (3), the height of the side ejection ports (20a) is higher than the height of upper ends of the electrodes (7) and constructed and arranged such that blow of the reaction gas fed from the gas feed pipe locally cools the polycrystalline silicon rod (X) at position L to lower the rate of silicon deposition at portions to where the reaction gas is blown and thereby form the recessed portion (51).

4. The production apparatus according to claim 3, wherein an upper ejection port (20b) is formed together with said side ejection ports (20a) in said gas ejection nozzle (20) so as to eject gas in an upper direction perpendicular to the upper surface of said bottom plate (3).

**Patentansprüche**

1.  Polykristalliner Siliciumstab, der durch Abscheiden und Wachsen von Silicium durch das chemische Gasphasenabscheidungsverfahren erhalten wird, auf einem Siliciumkernelement, das ein Paar Siliciumkemdrähte beinhaltet, die auf Elektroden errichtet sind, und einen Brückendraht, der obere Enden der Siliciumkemdrähte verbindet, wobei der polykristalline Siliciumstab gerade Körperabschnitte (50), die auf den Kerndrähten abgeschieden und gewachsen sind, und einen Brückenabschnitt, der auf dem Brückendraht abgeschieden ist, aufweisen; wobei:

    die geraden Körperabschnitte (50) des Siliciumstabs ein Durchmesserprofil in einer Längsrichtung davon aufweisen und ein minimaler Durchmesser in den geraden Körperabschnitten eingestellt wird, um 60 bis 95 % eines maximalen Durchmessers davon zu sein;
    ein vertiefter Abschnitt (51) in einem Abschnitt der geraden Körperabschnitte (50) nahe den Elektroden gebildet ist und der tiefste Abschnitt in dem vertieften Abschnitt ein Abschnitt ist, der den minimalen Durchmesser aufweist; und
    ein Verhältnis L/H der Position L des vertieften Abschnitts (51) von dem unteren Ende des geraden Körperabschnitts (50) zu der Höhe H des geraden Körperabschnitts (50) 0,05 zu 0,1 ist.

2.  Polykristalliner Siliciumstab, der durch Auseinanderschneiden der geraden Körperabschnitte (50) und des Brückenabschnitts des polykristallinen Silciumstabs nach Anspruch 1 auf eine Weise erhalten wird, in der der polykristalline Silciumstab den vertieften Abschnitt (51) beibehält, um zur Übertragung verwendet zu werden.

3.  Vorrichtung zum Herstellen des polykristallinen Silciumstabs (x) nach Anspruch 1, wobei die Vorrichtung Folgendes beinhaltet: eine Bodenplatte (3), die ein Paar Elektroden (7) hält; ein π-förmiges Siliciumkemelement (9), das ein Paar Silciumkemdrähte und einen Brückendraht umfasst, der obere Enden der Siliciumkemdrähte verbindet, wobei untere Enden der Silciumkerndrähte gehalten und auf dem Paar Elektroden (7) errichtet werden; und eine Glasglocke (5), die die Bodenplatte (3) abdeckt, um die Siliciumkemelemente (9) darin zu enthalten; wobei sich ein Gaszuführungsrohr (15) und ein Gasentladungsrohr (17) durch die Bodenplatte (3) in eine Reaktionskammer (A) erstreckt, die durch die Glasglocke (5) und die Bodenplatte (3) gebildet ist, **dadurch gekennzeichnet, dass**:
    eine Gasausstoßdüse (20) an einem Endabschnitt des Gaszuführungsrohrs (15) bereitgestellt ist und seitliche Ausstoßanschlüsse (20a) in der Gasausstoßdüse (20) gebildet sind, um Gas in eine Querrichtung parallel zu einer oberen Oberfläche der Bodenplatte (3) auszustoßen, die Höhe der seitlichen Ausstoßanschlüsse (20a) höher ist als die Höhe von oberen Enden der Elektroden (7) und konstruiert und angeordnet, sodass ein Blasen des Reaktionsgases, das von dem Gaszuführungsrohr zugeführt wird, den polykristallinen Siliciumstab (X) an Position L lokal kühlt, um die Geschwindigkeit der Siliciumabscheidung an Abschnitten zu verringern, zu denen das Reaktionsgas geblasen wird, und dadurch den vertieften Abschnitt (51) zu bilden.

4.  Herstellungsvorrichtung nach Anspruch 3, wobei ein oberer Ausstoßanschluss (20b) zusammen mit den seitlichen Ausstoßanschlüssen (20a) in der Gasausstoßdüse (20) gebildet ist, um Gas in eine obere Richtung senkrecht zu der oberen Oberfläche der Bodenplatte (3) auszustoßen.

**Revendications**

1.  Tige de silicium polycristallin obtenue par dépôt et croissance de silicium, par le procédé chimique de dépôt en phase vapeur, sur un élément central en silicium qui comprend une paire de fils centraux en silicium dressés sur des électrodes et un fil de liaison raccordant les extrémités supérieures desdits fils centraux en silicium, ladite tige de silicium polycristallin ayant des parties de corps droites (50) déposées et mises à croître sur lesdits fils centraux et une partie de liaison déposée sur ledit fil de liaison ; dans laquelle :

    les parties de corps droites (50) de ladite tige de silicium ont un profil de diamètre dans une direction de longueur de celle-ci, et un diamètre minimal dans lesdites parties de corps droites est ajusté pour être de 60 à 95 % de son diamètre maximal ;
    une partie évidée (51) est formée dans une partie des parties de corps droites (50) à proximité des électrodes, et la partie la plus profonde dans la partie évidée est une partie ayant le diamètre minimal ; et
    un rapport L/H entre la position L de la partie évidée (51) depuis l'extrémité de la partie de corps droite (50) et la hauteur H de la partie de corps droite (50) est de 0,05 à 0.1.

2.  Tige de silicium polycristallin obtenue par séparation par découpe des parties de corps droite (50) et de la partie de liaison des la tige de silicium polycristallin de la revendication 1 de manière à ce que la tige en silicium polycristallin conserve ladite partie évidée (50) de façon à être utilisée pour un transfert.

3. Appareil destiné à produire la tige en silicium polycristallin (x) de la revendication 1, l'appareil comprenant une plaque de base (3) portant une paire d'électrodes (7) ; un élément central en silicium en forme de $\pi$ (9) qui comprend une paire de fils centraux en silicium et un fil de liaison raccordant les extrémités supérieures desdits fils centraux en silicium, les extrémités inférieures desdits fils centraux en silicium étant tenues et dressées sur ladite paire d'électrodes (7) ; et une cloche de verre (5) couvrant la plaque de base (3) de façon à contenir lesdits éléments centraux en silicium (9) en son intérieur ; une conduit d'apport de gaz (15) et une conduit d'évacuation de gaz (17) s'étendant, à travers ladite plaque de base (3), dans une chambre de réaction (A) formée par ladite cloche de verre (5) et ladite plaque de base (3), **caractérisé en ce que** :
une buse d'éjection de gaz (20) est prévue au niveau d'une partie d'extrémité de ladite conduit d'apport de gaz (15), et des orifices d'éjection latéraux (20a) sont formés dans ladite buse d'éjection de gaz (20) de façon à éjecter du gaz dans une direction transversale parallèlement à une surface supérieure de ladite plaque de base (3), la hauteur des orifices d'éjection latéraux (20a) est plus haute que la hauteur des extrémités supérieures des électrodes (7) et conçue et agencée de sorte que l'afflux du gaz de réaction depuis la conduite d'apport de gaz refroidisse localement la tige de silicium polycristallin (X) en position L pour abaisser le taux de dépôt de silicium au niveau de parties sur lesquelles le gaz de réaction afflue et ainsi former la partie évidée (51).

4. Appareil de production selon la revendication 3, dans lequel un orifice d'éjection supérieur (20b) est formé conjointement auxdits orifices d'éjection latéraux (20a) dans ladite buse d'éjection (20) de façon à éjecter du gaz dans une direction supérieure perpendiculaire à la surface supérieure de ladite plaque de base (3).

Fig. 1

Fig. 2

Fig. 3

Fig. 4

Fig. 5

Fig. 6

Fig. 7

Fig. 8

**EP 2 402 287 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004149324 A

- JP 2005112662 A